# EUROPÄISCHE PATENTANMELDUNG

(11) **EP 1 041 649 A1**
(43) Veröffentlichungstag der Anmeldung: **04.10.2000**
(21) Anmeldenummer: 99106372.8
(22) Anmeldetag: 29.03.1999
(51) Int. Cl.: H01L 31/18

(54) **Verfahren zur Herstellung eines Dünnschichtsolarmoduls und eine Durchtrennungsvorrichtung**

(71) Anmelder: ANTEC Solar GmbH, 99334 Rudisleben (DE)
(72) Erfinder: Todisco, Alexandra, 64560 Riedstadt (DE); Bonnet, Dieter Dr., 61382 Friedrichsdorf (DE); Dinges, Peter, 60598 Frankfurt (DE)
(74) Vertreter: Lippert, Marianne

(57) **Zusammenfassung**

Verfahren und Durchtrennungsvorrichtung zum Herstellen eines Dünnschichtsolarmoduls (10) mit mehreren auf einem gemeinsamen Substrat (12) nebeneinander angeordneten Solarzellen (11), die durch Anwendung mehrerer Beschichtungsschritte und Schicht-Trennschritte während der Zellenherstellung erzeugt und zusammengeschaltet werden, wobei nach Aufbringen einer ersten Kontaktschicht (14) auf dem Substrat (12) und deren zellenweisem Auftrennen eine auf der durchtrennten Kontaktschicht aufgebrachte pn-Doppelschicht (16) mechanisch dadurch durchtrennt wird, daß ein als Durchtrennungsvorrichtung dienendes stichelförmiges Schneidwerkzeug durch eine Relativbewegung zum beschichteten Substrat die Zellenstruktur in die pn-Doppelschicht ritzt, wobei das Schneidwerkzeug, ohne angehoben oder verdreht zu werden, mit einer abgeplatteten Spitze auf der ersten Kontaktschicht (14) gleitet, die eine höhere Härte als die pn-Doppelschicht (16) aufweist.

## Beschreibung

Die Erfindung betrifft ein Verfahren zum Herstellen eines Dünnschichtsolarmoduls und eine Durchtrennungsvorrichtung zur Verwendung in diesem Verfahren.

Eine Herstellungsmöglichkeit eines Dünnschichtsolarmoduls mit mehreren auf einem gemeinsamen Substrat parallel angeordneten Solarzellen, die durch mehrere zellenübergreifende Beschichtungsschritte und Schicht-Trennschritte während der Zellenherstellung erzeugt und zusammengeschaltet werden, ist bereits in der US 4 243 432 beschrieben worden. Dort werden CdS-CuₓS- Solarzellen dadurch hergestellt, daß ein Glassubstrat stets vollständig nacheinander mit den einzelnen Schichten versehen wird, nämlich in der Hauptsache einer als untere Elektrode dienenden harten Kontaktschicht aus SnOₓ und einer darüber liegenden pn-Doppelschicht aus CdS-CuₓS sowie einer als obere Elektrode dienenden weiteren Kontaktschicht. Zwischen den einzelnen Beschichtungsschritten soll durch parallele Schnitte dafür gesorgt werden, daß einerseits die Aufteilung der zellenübergreifenden Substratbeschichtung in einzelne Zellen erzielt wird und andererseits die Zellen eines Substrats auch elektrisch hintereinander geschaltet werden. Zur seriellen Zusammenschaltung der Zellen wird durch die Schnittsetzung dafür gesorgt, daß die obere Elektrode einer Zelle 1 die untere Elektrode der folgenden Zelle 2 berührt, hingegen von der oberen Elektrode der Zelle 2 getrennt ist. Dieses Schema wird über die gesamte Substratlänge fortgesetzt. Es werden verschiedene Trennverfahren für die einzelnen Schichten u.a. mit Ultraschalltechnik vorgeschlagen, und es ist ausgeführt, daß die pn-Schicht auch mechanisch beispielsweise mit einem rotierenden oder nicht rotierenden Schneidwerkzeug trennbar ist.

Die bisher im Handel erhältlichen Silizium-Solarzellenmodule werden allerdings aus einzelnen Zellen aufgebaut, die mit Hilfe von angelöteten Metallbändern verschaltet sind. Module mit CdS-CuₓS- Solarzellen sind bislang nicht nach dem oben aufgezeigten Verfahren industriell hergestellt worden. Das gleiche gilt für die seit geraumer Zeit als erfolgversprechende Kandidaten geltende CdS/CdTe-Solarzellen mit einem an das Glassubstrat angrenzenden Frontkontakt aus einer lichtdurchlässigen TCO-Schicht, zumeist in Form der sogenannten ITO-Schicht . Hinsichtlich Herstellung und Aufbau einer solchen einzelnen Solarzelle wird ausdrücklich auf die EP 0 535 522 verwiesen.

Die Erfinder der vorliegenden Anmeldung standen vor der Aufgabe, ein Verfahren zu entwickeln, mit dem eine rationelle Fertigung von Dünnschichtsolarmodulen unter Ausnutzung einer zellenübergreifenden Beschichtung durch eine schnelle Trenntechnik möglich ist. Ferner sollte eine geeignete Trennvorrichtung zur Verwendung im Verfahren gefunden werden, die ein derartiges schnelles Trennen ermöglicht. Ein schnelles Trennen ist deshalb erforderlich, weil die Trennschritte Teil des Durchlaufprozesses sind und nicht von diesem abgekoppelt werden können.

Die im Anspruch 1 gekennzeichnete Lösung zeichnet sich dadurch aus, daß man für die pn-Schicht ein ritzendes stichelförmiges Schneidwerkzeug einsetzt. Dieses wird allerdings entgegen der sonst üblichen Technik der Anwendung von nicht rotierenden Schneidwerkzeugen wie Sticheln weder während des Schneidbetriebs noch beim Vorschieben des Werkzeugs in einen neuen Arbeitsbereich vom beschichteten Substrat abgehoben. Durch ein Vermeiden des Anhebens und des Wiederabsenkens des Werkzeugs auf der Frontkontaktschicht konnten die Standzeit des Schneidwerkzeugs erhöht werden und die Rationalität des Verfahrens gesteigert werden. Auch wird das Werkzeug z.B. vor dem Weiterschieben in einen neuen Arbeitsbereich nicht verdreht. Entgegen üblichen Schneidvorrichtungen weist das erfindungsgemäß eingesetzte Schneidwerkzeug eine abgeplattete Spitze auf, wobei die durch die Abplattung geschaffene ebene Fläche als Gleitfläche des Werkzeugs dient. Mit dieser Gleitfläche gleitet das Werkzeug während des Trennvorgangs auf der ersten Kontaktschicht, wobei die Gleitfläche ganzflächig auf dieser zu ihr parallelen Schicht aufliegt.

Versuche der Erfinder mit Schneidwerkzeugen mit rotierendem Schneidkopf oder periodisch vom Substrat abzuhebenden und wieder abzusenkenden Schneidwerkzeugen brachten nicht den gewünschten Erfolg im Hinblick auf ein rationelles Verfahren.

Bevorzugte Weiterbildungen des Verfahrens sind in den Unteransprüchen gekennzeichnet.

Das erfindungsgemäße Verfahren eignet sich besonders gut für die genannten CdS/CdTe-Solarzellen mit einem Frontkontakt aus einer harten und glatten TCO-Schicht wie der ITO-Schicht, die um etwa den Faktor zehn härter ist als die weiche, spröde pn-Schicht. Auf diese Weise ist es möglich, die pn-Schicht zu durchtrennen, ohne in das Frontkontaktmaterial einzudringen, auf dem das Schneidwerkzeug beim Durchtrennen der pn-Schicht mit seiner abgeplatteten Spitze gleitet. Das Verfahren ist dadurch besonders rationell, daß das Schneidwerkzeug vor dem Weiterschieben in der zweiten Vorschubrichtung nicht abgehoben wird, sondern lediglich in eine anderen zweiten Vorschubrichtung weitergeschoben wird. Da vorzugsweise das gesamte Substrat mit der pn-Schicht versehen wird, durchtrennt das Schneidwerkzeug beim Weiterschieben ebenfalls die pn-Schicht und gleitet auf der Frontkontaktschicht. Das Verfahren deckt jedoch auch den Fall ab, daß das Schneidwerkzeug in der zweiten Vorschubrichtung in einem pn-schichtfreien Bereich des Substrats auf der Frontkontaktschicht weitergeschoben wird.

Beim Weiterschieben in der zweiten Vorschubrichtung wird nicht die erste Schneidkante des Schneidwerkzeugs benutzt, sondern eine andere Werkzeugseite in die zweite Vorschubrichtung bewegt. Das vorzugsweise mit rechteckiger Gleitfläche versehene Schneidwerkzeug wird nach dem Weiterschieben, wieder ohne abzuheben oder um seine Längsachse gedreht zu werden, entgegengesetzt zur ersten Vorschubrichtung bewegt.

Von konstruktivem Vorteil ist es, die Relativbewegung in der ersten Vorschubrichtung, in der die pn-Schicht durchtrennt wird, nur durch Bewegen des oder der Schneidwerkzeuge zu bewerkstelligen.

Vorzugsweise wird das Schneidwerkzeug mit seiner Gleitfläche federnd gegen das beschichtete Substrat gedrückt. Sonst in der Werkstückbearbeitungstechnik aufwendige Justierungsmaßnahmen von fest eingespannten Schneidwerkzeugen entfallen. Mit dem federnd gegen die Frontkontaktschicht gedrückten erfindungsgemäßen Schneidwerkzeug wird stets die pn-Schicht zuverlässig durchtrennt.

Das Verfahren konnte durch weitere Optimierung der Standzeit des Schneidwerkzeugs noch mehr rationalisiert werden, weil zu Beginn des Schneidwerkzeugeinsatzes mit einem Werkzeug gearbeitet wird, dessen Spitzenabplattung einen geringst möglichen Wert hat, der durch Abrieb während der Einsatzdauer zunimmt. Im Verfahren wird die Einsatzdauer so begrenzt, daß diese Abplattung in einem tolerierbaren Bereich liegt, in dem das Werkzeug noch ausreichend durchtrennt. Demgegenüber wird zu Anfang mit einer geringen Spitzenabplattung gearbeitet, bei der die Werkzeugspitze, ohne die erste Kontaktschicht zu beschädigen, auf dieser gleitet. Hierbei spielt auch die Andruckkraft des Werkzeugs unter Einbeziehung der eingestellten Federwirkung eine Rolle. Vorzugsweise wird die Andruckkraft mit abriebbedingter Flächenzunahme der abgeplatteten Spitze vergrößert, um stets einen gleichen optimalen Druck zu erzeugen. Die durch die Feder ausgeübte Kraft wird so eingestellt, daß einerseits die erste Kontaktschicht nicht beschädigt wird und andererseits ein Aufgleiten des Werkzeugs verhindert wird.

Die im Anspruch 9 gekennzeichnete erfindungsgemäße Durchtrennungsvorrichtung zur Durchführung des Verfahrens ist ein einfach und kostengünstig herzustellendes Schneidwerkzeug. Mit diesen Eigenschaften eignet sich das auszuwechselnde Werkzeug für die angestrebte Massenproduktion von Dünnschichtsolarmodulen. Das Werkzeug ist stichelförmig, jedoch mit abgeplatteter Spitze, und vorzugsweise mit den in den Unteransprüchen 10 bis 13 gekennzeichneten Merkmalen ausgeführt.

So wurde gefunden, daß sich besonders große Durchtrennungsstrecken bis zu 20 km mit rechteckiger Gleitfläche und vorzugsweise ungleich langen Schneidkanten erzielen ließen, ohne daß das Werkzeug ausgetauscht und der Herstellungsprozeß unterbrochen werden mußten. Vorzugsweise wird ferner mit einer Spitze nach Art eines umgekehrten vierseitigen, geraden Pyramidenstumpfes als Werkzeugspitze gearbeitet, mit dem die erste Vorschubrichtung oder Hauptritzrichtung unter gleichen Durchtrennungsbedingungen umkehrbar ist.

Auch wurde gefunden, daß sich mit den ungleich langen Schneidkanten in Hauptritzrichtung und der vorzugsweise hierzu rechtwinkligen Verschiebungsrichtung ein optimales Verhältnis von auf das Schneidwerkzeug aufzubringender Kraft und Flächenpressung erzielen läßt. Ein solches erfindungsgemäßes Schneidwerkzeug bietet zudem den Vorteil, daß es auch noch bei einem leichten Schräglauf zufriedenstellende Schnitte ausführt, wobei zusätzlich zur Schneidkante in Hauptritzrichtung die Schneidkante in der Verschiebungsrichtung zum Tragen kommt. Hierdurch ist es möglich, auch ohne aufwendige Nachjustierungen der relativen Winkelausrichtung von Substrat und Werkzeug parallele Schnitte auf dem Substrat zu gewährleisten.

Bei einer CdS/CdTe pn-Doppelschicht, in der die CdS-Schicht eine Dicke im Bereich von nur 100 nm oder weniger aufweist, haftet diese dünne CdS-Schicht so stark auf der ersten Kontaktschicht, daß sie von dem Schneidwerkzeug nicht abgetragen wird. Da die CdS-Schicht jedoch derart dünn ist, zeigt sie praktisch die Härte der darunter liegenden harten ersten Kontaktschicht. Für die abgeplattete Werzeugspitze ergeben sich somit gleiche Gleitbedingungen. Bei dickeren CdS-Schichten kommt deren Sprödigkeit immer mehr zum Tragen, so daß sie dann zusammen mit der CdTe-Schicht abgetragen werden.

Im folgenden wird die Erfindung anhand der Zeichnungen näher erläutert. Es zeigen:
Figur 1 eine schematische Darstellung eines Dünnschichtsolarmoduls mit von leitfähigem Material befreitem Randbereich von oben;
Figur 2 eine Querschnittsansicht durch einen Teil des Moduls nach Figur 1;
Figur 3 eine Seitenansicht eines bevorzugten Ausführungsbeispiels eines erfindungsgemäßen stichelförmigen Schneidwerkzeugs;
Figur 4 eine Seitenansicht des Schneidwerkzeugs in Richtung des Pfeils der Figur 3;
Figur 5 eine gegenüber Figur 3 vergrößerte Darstellung der Schneidwerkzeugspitze;
Figur 6 eine gegenüber Figur 4 vergrößerte Darstellung der Schneidwerkzeugspitze;
Figur 7 ist eine wiederum gegenüber Figur 4 vergrößerte Ansicht der Schneidwerkzeugspitze von unten;
Figur 8 eine gegenüber Figur 7 vergrößerte Teilansicht der Schneidwerkzeugspitze;
Figur 9 eine schematische perspektivische Ansicht vom unteren Ende der Schneiwerkzeugspitze; und
Figur 10 eine schematische Seitenansicht eines Werkzeughalters mit mehreren darin aufgenommenen Schneidwerkzeugen in Arbeitsstellung über einem auf einem Tisch angeordneten Modulsubstrat.

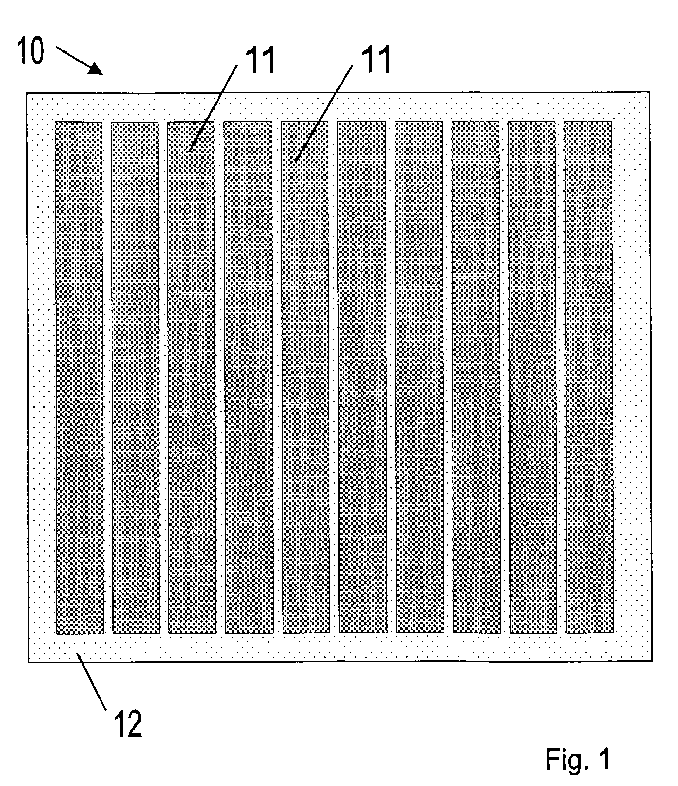

Das Dünnschichtsolarmodul 10 der Figur 1 zeigt zehn auf einem Glassubstrat 12 parallel nebeneinander angeordnete Solarzellen 11 nach dem Durchtrennen der pn-Schicht (bevorzugt CdS/CdTe-Schicht) vor dem Aufbringen der Rückkontaktbeschichtung. Ein typisches Modul hat etwa 100 individuelle Zellen pro Meter seiner Länge. Es sind daher zur Strukturierung des Moduls eine Vielzahl von Schnitten über große Schnittlängen auszuführen.

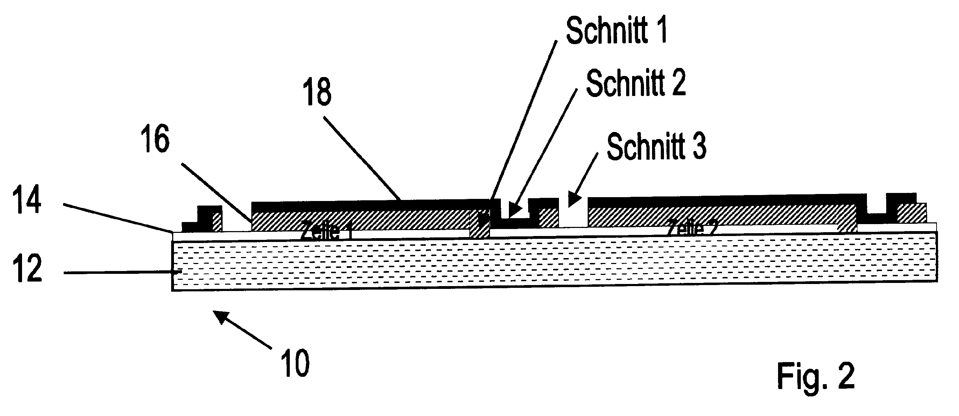

Die Schnittansicht der Figur 2 zeigt das Substrat 12 mit aufgebrachtem Rückkontakt 18. Auf dem Glassubstrat 12 aus vorzugsweise Fensterglas liegt eine TCO-Schicht 14, die mit einem Schnitt 1 zellenweise unterbrochen ist. Dieser Schnitt von im Ausführungsbeispiel etwa 100 um Breite wird mit einem Laser, beispielsweise einem Neodym-YAG-Laser, nach Aufbringen der TCO-Schicht durch Ablation erzeugt. Dieser erste Schnitt bestimmt die Breite der in Serie zu verschaltenden Zellen.

Nach Aufbringen der pn-Doppelschicht 16 vorzugsweise durch CdS-Abscheidung und darauffolgende CdTe-Abscheidung und Aktivierung dieser Schicht wird das abgekühlte Modul einem Schnitt 2 unterzogen, bei dem es sich um einen ersten mechanischen Trennschnitt mit dem erfindungsgemäßen Schneidwerkzeug handelt. Der Schnitt 2 durchtrennt die pn-Schicht 16 nahe dem ersten Schnitt 1 bis zur TCO-Schicht 14. Die Breite des Schnitts beträgt im Ausführungsbeispiel zu Anfang etwa 0,06mm.

Bei einer CdS/CdTe pn-Doppelschicht, in der die CdS-Schicht im Vergleich zur etwa 3 bis 7 µm dicken CdTe-Schicht eine Dicke im Bereich von nur 100 nm oder weniger aufweist, wird die CdS-Schicht, wie weiter oben dargelegt, nicht abgetragen. Die Funktion der seriellen Verschaltung wird durch den Verbleib der CdS-Schicht nur unwesentlich beeinflußt.

Anschließend wird der Rückkontakt 18 (bevorzugt eine Doppelschicht aus einer Halbleiterschicht, z.B. Tellur, und einer Metallschicht, z.B. Nickel) aufgedampft. Anschließend erfolgt Schnitt 3 wiederum mit dem erfindungsgemäßen Schneidwerkzeug unter gleichzeitiger Durchtrennung des Rückkontakts 18 und der pn-Schicht 16.

Die Schnitte 1 bis 3 verlaufen in Längsrichtung der streifenförmigen Zellen 11 gemäß Darstellung in Figur 1. Das Werkzeug wird nach Ausführung eines solchen Längsschnitts vorzugsweise im noch beschichteten Substratrandbereich quer zur Längsrichtung der Zellen 11, ohne abzuheben und um seine Längsachse verdreht zu werden, verschoben. Anschließend wird der nächste Längsschnitt mit zum vorhergehenden Längsschnitt entgegengesetzter Vorschubrichtung des Werkzeugs vorgenommen. Das Werkzeug wird somit mäander- oder rechteckwellenförmig relativ zum Substrat bewegt. Mit dem erfindungsgemäßen Werkzeug können ohne weiteres Schnittgeschwindigkeiten von 30m/min realisiert werden. Für die Produktion wird bei Einsatz mehrerer parallel schneidender Schneidwerkzeuge bei den vorgegebenen Modulen mit einer Geschwindigkeit von etwa 10m/min gearbeitet.

Während des Schneidvorgangs werden die Schneidabfälle abgesaugt. Eine Reinigung des beschichteten Substrats vor dem nächsten Beschichtungsschritt ist nicht erforderlich.

Wie weiter oben erläutert, wird die Hintereinanderschaltung der Zellen dadurch erzielt, daß der Rückkontakt der Zelle 1 mit dem Frontkontakt, d.h. der TCO-Schicht 14 der Zelle 2 verbunden ist, usw.

Prinzipiell können die Zellen unter Verwendung der hier beschriebenen Trenntechnik auch anders verschaltet werden.

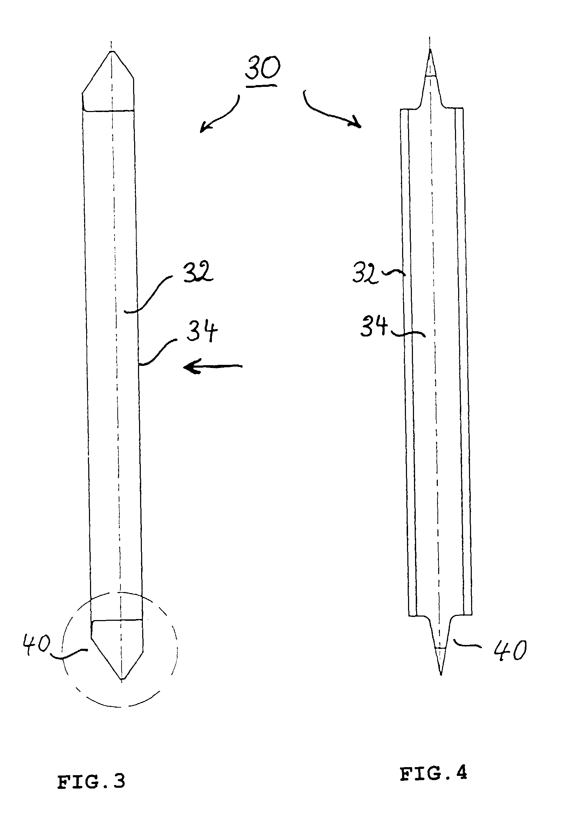

Das in den Figuren 3 bis 7 gezeigte stichelförmige Schneidwerkzeug 30 weist eine Spitze 40 in Form eines umgekehrten Kegelstumpfes auf. Gemäß der bevorzugten Ausführung wird in der Zeichnung eine vierseitige gerade Pyramide mit zwei unterschiedlich langen Grundkanten 42 und 44 der unteren Grundfläche 41 des Stumpfes zugrunde gelegt. Diese Grundkanten bilden eine erste und zweite Schneidkante des Werkzeugs. Die sich von der ersten und zweiten Schneid- oder Grundkante 42, 44 erstreckenden Seitenflächen des Pyramidenstumpfes, die die Spanflächen des Schneidwerkzeugs bilden, weisen unterschiedlich große Öffnungswinkel α und β auf. Der erste kleinere Winkel α definiert die Spanfläche 46 in einer ersten Haupt-Ritzrichtung des Werkzeugs 30 und der zweite größere Winkel β definiert die größere Spanfläche 48 in einer zweiten Ritzrichtung zur Verschiebung des Werkzeugs 30. Der erste Winkel α bestimmt die Schnittbreite des Werkzeugs, die im Verlaufe der abriebbedingten Abnutzung bis zu einem tolerierbaren Wert zunimmt.

Im Ausführungsbeispiel betragen die Winkel α = 20° und β = 70°. Die kürzere Schneid- oder Grundkante 42 der rechteckigen Gleitfläche 41, die der Grundfläche des Pyramidenstumpfes entspricht, hat im Ausführungsbeispiel eine ursprüngliche Breite von etwa 0,06 mm. Im Ausführungsbespiel beträgt die durch die Modulauslegung vorgegebene maximale Schnittbreite etwa 0,1 mm. Die zugehörige Spanfläche 46 schließt im Ausführungsbeispiel im Einsatz des Werkzeugs 30 mit der beschichteten Substratebene bzw. der verlängerten Gleitfläche 41 einen Winkel von γ= 55° ein, der in der Hauptritzrichtung oder Zellenlängsrichtung zur Wirkung kommt. Dagegen schließt die größere Spanfläche 48 mit der Substratebene einen Winkel von 80° ein, der in Zellenquerrichtung, d.h. der Verschiebungsrichtung für das Werkzeug zur Wirkung kommt. In dieser Richtung sind Trennwirkung und Schnittbreite des Werkzeugs in der pn-Doppelschicht bei diesem Ausführungsbeispiel nicht von Bedeutung, da der Randbereich des Substrats nach Aufbringen des Rückkontakts 18 bei der Fertigstellung des Moduls völlig entschichtet wird. Bei dieser Entschichtung werden die Strukturen beseitigt, die bei der Bewegung des Werkzeugs in Verschiebungsrichtung in den Substratschichten hervorgerufen wurden.

Der Pyramidenstumpf 40 geht in einen zylinderförmigen Schaft 32 über, der in der dargestellten Weise einseitig mit einer ebenen Führungsfläche 34 versehen ist.

Ferner ist in der gezeigten Ausführung das Werkzeug 30 beidseitig mit einer abgeplatteten Spitze 40 versehen, so daß nach Abnutzung einer Spitze die andere Spitze eingesetzt werden kann.

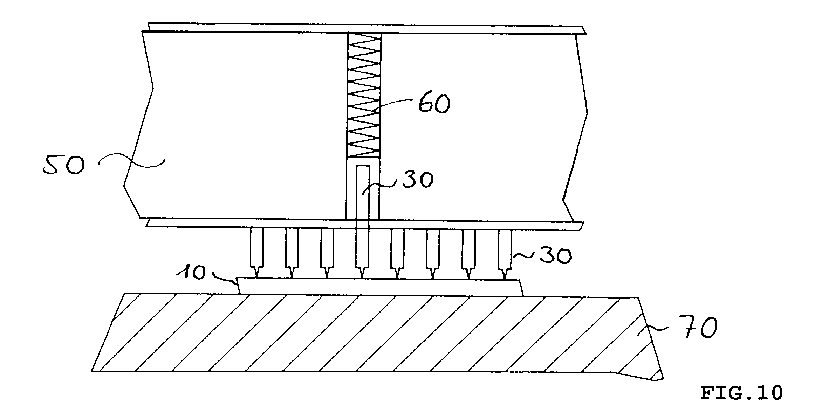

Die Figur 10 zeigt einen Werkzeughalter 50, in dem mehrere der Werkzeuge 30 aufgenommen sind. Die Werkzeuge bearbeiten gleichzeitig mehrere nebeneinander liegende Zellen auf einem Substrat 10, das auf einem Tisch 70 fixiert ist. Jedes einzelne Werkzeug 30 ist senkrecht zu seiner Gleitfläche 41 von einer Feder 60 beaufschlagt. Die Werkzeuge 30 sind mittels ihrer Führungsfläche 34 im Werkzeughalter unverdrehbar in Längsrichtung verschieblich geführt und werden federnd gegen das Substrat 10 gedrückt.

Die Federkraft wird so eingestellt, daß das Werkzeug beim Anfahren die voneinander zu trennenden Schichten durchbricht und im Verlaufe der durchtrennenden Bewegung ständig auf der Kontaktschicht 40 gleitet. Wie weiter oben dargelegt, wird die Federkraft vorzugsweise mit Zunahme der Größe der Gleitfläche erhöht, um einen angenähert gleichen Andruck zu gewährleisten. Für die Materialien und Geometrien des Ausführungsbeispiels wurde ein möglicher Druckbereich von einigen hundert N/mm² bis etwa 1000 N/mm² ermittelt.

Im Ausführungsbeispiel wird der Werkzeughalter 50 durch nicht dargestellte Mittel in Zellenlängsrichtung verfahren und zwischen den in entgegengesetzten Richtungen vorgenommenen Verfahrschritten wird der Tisch quer zur Zellenlängsrichtung um die Anzahl der mit den Werkzeugen bearbeiteten Zellen verschoben.

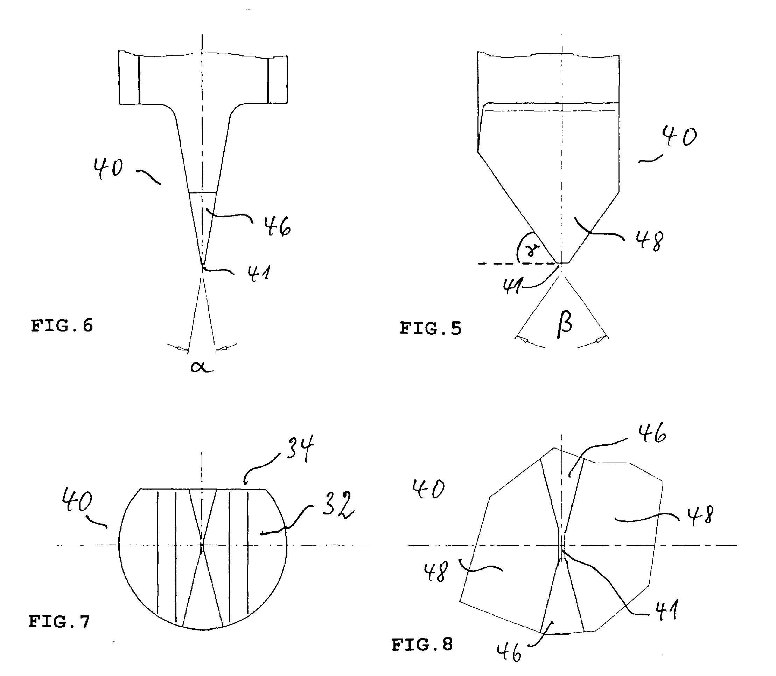

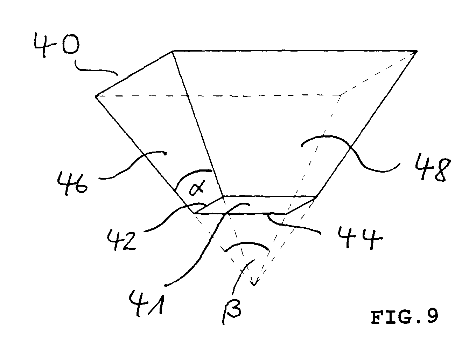

Es sei darauf hingewiesen, daß man das erfindungsgemäße Schneidwerkzeug auch ohne die dargelegten zwei Vorschubrichtungen betreiben kann. So könnte man prinzipiell ausreichend viele Schneidwerkzeuge für sämtliche Zellen eines Substrats in einem Halter nebeneinander anordnen, so daß mit einem einzigen synchronen Längsschnitt die Strukturierung jeder Schicht erzielbar ist. Speziell in diesem Fall könnte man beispielsweise auch eine Spitze in Form eines dreiseitigen Pyramidenstumpfes im erfindungsgemäßen Schneidwerkzeug verwenden. Prinzipiell brauchte die Werkzeugspitze bei einer solchen Ausführung nur eine einzige Schneidkante, so daß die abgeplattete Werkzeugspitze auch halbrund sein könnte. In solchen geometrischen Ausbildungen der Werkzeugspitze ist es ebenfalls von Vorteil, wenn der Winkel zwischen der sich über der Schneidkante erstrekkenden Spanfläche (entsprechend Fläche 46 in Figur 9) und der Verlängerung der abgeplatteten Grundfläche 41 der Werkzeugspitze (bzw. der Schnittfläche) entsprechend dem Winkel γ in Figur 5 zwischen 40°und 90° liegt.

Statt des erläuterten Pyramidenstumpfes bietet ein umgekehrter Kegelstumpf eine weitere mögliche Ausgestaltung der Spitze des erfindungsgemäßen Werkzeugs. Eine solche Form wird bevorzugt zum Herstellen gekrümmter, beispielsweise kreisförmiger Schnittstrukturen eingesetzt.

Bei der kegelstumpfartigen Ausbildung nimmt die abriebbedingte Zunahme der Gleitflächenbreite in Hauptritzrichtung mit kleineren Werten von α ab. Damit kann zwar die Standzeit des Werkzeugs gesteigert werden, gleichzeitig ist jedoch die Stabilität des Werkzeugs geringer, die man durch Vergrößern von β nur in gewissem Ausmaß steigern kann. Bei einem bevorzugten Bereich von α zwischen 15° und 40° haben sich für β Werte im Bereich von 100° bis 50° als zweckmäßig erwiesen, die bei Voraussetzung eines vorgegebenen Schneidkantenverhältnisses und geometrisch exakten Pyramidenstumpfes aus den Werten von α berechnet werden können. Der Fachmann wird je nach zu durchtrennendem Material und der Härte der Frontkontaktschicht im Hinblick auf eine möglichst hohe Schneidgeschwindigkeit und Standzeit des Werkzeugs Werte ermitteln, die für seine Anforderungen den bestmöglichen Kompromiß darstellen.

Dabei muß er nicht, wie im bevorzugten Ausführungsbeispiel, einen geometrisch exakten geraden, vierseitigen Pyramidenstumpf voraussetzen, sondern kann auch solche Öffnungswinkel miteinander kombinieren, bei denen die Verlängerungen der Spanflächen nicht in einer gemeinsamen Spitze zusammentreffen. Eine leichtere reproduzierbare Fertigung ergibt sich allerdings bei einem geometrisch exakten Pyramidenstumpf. Auch lassen sich hier infolge des konstanten Schneidkantenverhältnisses die abriebbedingte Flächenzunahme und die Andruckkraftanpassung leichter berechnen.

Die im Ausführungsbeispiel nicht gleichseitige rechteckige Gleitfläche kann auch durch eine quadratische ersetzt werden. Dies ist dann von Vorteil, wenn nicht nur Längsschnitte sondern auch quer verlaufende Schnitte gleicher Breite in einer pn-Schicht erzeugt werden sollen.

Im Ausführungsbeispiel besteht das erfindungsgemäße Schneidwerkzeug aus Widia-Stahl. Außer anderen Hartmetallen würde sich prinzipiell auch eine diamantene abgeplattete Werkzeugspitze eignen.

## Patentansprüche

1. Verfahren zum Herstellen eines Dünnschichtsolarmoduls (10) mit mehreren auf einem gemeinsamen Substrat (12) nebeneinander angeordneten Solarzellen (11), die durch Anwendung mehrerer Beschichtungsschritte und Schicht-Trennschritte während der Zellenherstellung erzeugt und zusammengeschaltet werden,
dadurch gekennzeichnet,
daß nach Aufbringen einer ersten Kontaktschicht (14) auf dem Substrat (12) und deren zellenweisem Auftrennen eine auf der durchtrennten Kontaktschicht aufgebrachte pn-Doppelschicht (16) mechanisch dadurch durchtrennt wird, daß ein als Durchtrennungsvorrichtung dienendes stichelförmiges Schneidwerkzeug (30) durch eine Relativbewegung zum beschichteten Substrat die Zellenstruktur in die pn-Doppelschicht ritzt, wobei das Schneidwerkzeug, ohne angehoben oder verdreht zu werden, mit einer abgeplatteten Spitze (40) auf der ersten Kontaktschicht (14) gleitet, die eine höhere Härte als die pn-Doppelschicht (16) aufweist.

2. Verfahren nach Anspruch 1,
dadurch gekennzeichnet,
daß nach Aufbringen einer zweiten Kontaktschicht (18) auf die pn-Doppelschicht (16) diese zweite Kontaktschicht ebenfalls mittels des stichelförmigen Schneidwerkzeugs (30), ohne daß dieses angehoben oder verdreht wird, zusammen mit der darunterliegenden pn-Doppelschicht (16) durchtrennt wird, wobei die abgeplattete Schneidwerkzeugspitze (40) auf der ersten Kontaktschicht (14) gleitet.

3. Verfahren nach Anspruch 1 oder 2,
dadurch gekennzeichnet,
daß die pn-Doppelschicht (16) mit einer ersten Schneidkante (42) des Schneidwerkzeugs (30) in einer ersten Vorschubrichtung durchtrennt wird und daß das Schneidwerkzeug in einer zweiten Vorschubrichtung auf dem Substrat weitergeschoben wird.

4. Verfahren nach Anspruch 3,
dadurch gekennzeichnet,
daß eine mehrere nebeneinander angeordnete Zellen (11) umfassende Zellengruppe durch mehrere gemeinsam in der ersten Vorschubrichtung geführte Schneidwerkzeuge (30) synchron geritzt wird, die anschließend zu einer noch nicht geritzten Zellengruppe in der zweiten Vorschubrichtung, vorzugsweise senkrecht zur ersten Vorschubrichtung, weitergeschoben werden.

5. Verfahren nach Anspruch 3 oder 4,
dadurch gekennzeichnet,
daß die Relativbewegung in der ersten Vorschubrichtung durch Bewegen des Schneidwerkzeugs (30) und in der zweiten Vorschubrichtung durch Bewegen des Substrats (10) bewerkstelligt wird.

6. Verfahren nach einem der vorhergehenden Ansprüche,
dadurch gekennzeichnet,
daß das Schneidwerkzeug (30) mit seiner abgeplatteten Spitze (40) federnd gegen die beschichtete Substratfläche gedrückt wird.

7. Verfahren nach einem der vorhergehenden Ansprüche,
dadurch gekennzeichnet,
daß das Schneidwerkzeug (30) mit anfangs minimal zulässiger Breite seiner Schneidkante (42) solange eingesetzt wird, bis durch abriebbedingte Zunahme der Breite eine maximal zulässige Breite erreicht wird.

8. Verfahren nach einem der vorhergehenden Ansprüche,
dadurch gekennzeichnet,
daß bei einer CdS/CdTe pn-Doppelschicht, in der die CdS-Schicht eine Dicke im Bereich von nur 100 nm oder weniger aufweist, die abgeplattete Spitze (40) des Schneidwerkzeugs (30) statt auf der ersten Kontaktschicht (14) auf der mit der dünnen CdS-Schicht behaftenen ersten Kontaktschicht gleitet.

9. Durchtrennungsvorrichtung zur Verwendung im Verfahren nach einem der Ansprüche 1 bis 8,
gekennzeichnet durch mindestens ein stichelförmiges Schneidwerkzeug (30) mit einer abgeplatteten Spitze (40), deren Abplattung eine ebene Gleitfläche des stichelartigen Werkzeugs vorsieht, vorzugsweise in Form nach Art eines umgekehrten Pyramidenstumpfes, dessen kleinere Grundfläche (41) diese Gleitfläche bildet.

10. Durchtrennungsvorrichtung nach Anspruch 9,
dadurch gekennzeichnet,
daß die Gleitfläche (41) des Schneidwerkzeugs eine erste und einer zweite Schneidkante (42, 44) für eine erste und eine zweite Vorschubrichtung des Schneidwerkzeugs (30) vorsieht.

11. Durchtrennungsvorrichtung nach Anspruch 10,
dadurch gekennzeichnet,
daß die Gleitfläche (41) rechteckig ist mit vorzugsweise kleinerer erster Schneidkante (42) für die erste Vorschubrichtung als Hauptritzrichtung und längerer zweiter Schneidkante (44) für die zweite Vorschubrichtung als Verschiebungsrichtung.

12. Durchtrennungsvorrichtung nach Anspruch 11,
dadurch gekennzeichnet,
daß der pyramidenstumpfartigen Form eine vierseitige, gerade Pyramide zugrunde liegt und daß die sich von der ersten und zweiten Schneidkante (42, 44) erstreckenden Seitenflächen des Pyramidenstumpfes, die die Spanflächen (46, 48) des Schneidwerkzeugs (30) bilden, unterschiedlich große Öffnungswinkel (α, β) mit einem kleineren Winkel (α) für die Hauptritzrichtung und einem größeren Winkel (β) für die Verschiebungsrichtung aufweisen.

13. Durchtrennungsvorrichtung nach einem der Ansprüche 9 bis 12,
dadurch gekennzeichnet,
daß das stichelförmige Schneidwerkzeug (30) aus Hartmetall, vorzugsweise Widia-Stahl, besteht.
